# EUROPEAN PATENT APPLICATION

(11) **EP 4 610 677 A1**
(43) Date of publication of application: **03.09.2025**
(21) Application number: 22963814.3
(22) Date of filing: 01.11.2022
(51) Int. Cl.: G01R 31/327, H01H 47/00

(54) **STATUS DETECTION METHOD FOR SWITCH MODULE, CIRCUIT, DEVICE, AND STORAGE MEDIUM**

(71) Applicant: Contemporary Amperex Technology Co., Limited, Ningde, Fujian 352100 (CN); Contemporary Amperex Intelligence Technology (Shanghai) Limited, Shanghai 201306 (CN)
(72) Inventor: LI, Pengtao, Shanghai 200120 (CN); GONG, Xiaofeng, Shanghai 200120 (CN); ZHUANG, Zhaohui, Shanghai 200120 (CN); PENG, Long, Shanghai 200120 (CN); MA, Guolong, Shanghai 200120 (CN)
(74) Representative: Gong, Jinping
(86) International application number: PCT/CN2022/128917
(87) International publication number: WO 2024/092495

(57) **Abstract**

Embodiments of the present application provide a state detection method, circuit, and device for a switch module, and a storage medium. The state detection method for a switch module includes: connecting a battery pack to a switch module when the switch module is disconnected, so that the battery pack forms a first charge loop with an energy storage element through the switch module; performing voltage detection on the energy storage element to obtain a first detection voltage; and determining, according to the first detection voltage, whether the switch module is completely disconnected.

## Description

### TECHNICAL FIELD

The present application relates to the field of switch control technologies, and more particularly to a state detection method, circuit, and device for a switch module, and a storage medium.

### BACKGROUND

With the development of new energy technologies, batteries are increasingly widely applied in various electrical apparatuses, such as in mobile phones, notebook computers, battery cars, electric vehicles, electric airplanes, electric boats, and the like.

Taking the electric vehicle among the electrical apparatuses as an example, in a low-temperature environment, a battery pack in the electric vehicle is low in charging efficiency, and the battery pack needs to be heated. The temperature of the battery pack is hated to an operating temperature range of the battery pack before the battery pack is capable of being efficiently charged through a charge device. In addition, existing electric vehicles usually use high-voltage systems and need to be charged on high-voltage charge platforms. However, most charge devices deployed in the past are low-voltage platforms and are not compatible with electric vehicles having high-voltage systems.

In order to realize new functions, existing electrical apparatuses usually add new topology circuit designs on the basis of original modules and components of the electrical apparatuses, and realize switching of various functions through on-off control of switch components However, when an anomaly occurs in a switch component, components inside the circuit will be damaged.

### SUMMARY OF THE INVENTION

The present application provides a state detection method, circuit, and device for a switch module, and a storage medium, which is capable of solving the technical problem that components inside a circuit are damaged when an anomaly occurs in a switch component.

In a first aspect, an embodiment of the present application provides a state detection method for a switch module, the method including:
connecting a battery pack to a switch module when the switch module is disconnected, so that the battery pack forms a first charge loop with an energy storage element through the switch module;
performing voltage detection on the energy storage element to obtain a first detection voltage; and
determining, according to the first detection voltage, whether the switch module is completely disconnected.

By connecting the battery pack to the switch module, it can be determined whether the switch module is completely disconnected when the switch module is in a disconnected state. If the switch module is not completely disconnected, the battery pack is capable of charging the energy storage element through the switch module, so that the first detection voltage obtained by detection is large. If the switch module is completely disconnected, the battery pack cannot charge the energy storage element, so that the first detection voltage obtained by detection is small. Whether the switch module is in a completely disconnected state when it is disconnected can be determined according to the magnitude of the first detection voltage. When the switch module is completely disconnected, the electrical apparatus can be switched to operate in a mode when the switch module is disconnected, thereby implementing a corresponding function. When the switch module is not completely disconnected, the electrical apparatus cannot be switched to operate in the mode when the switch module is disconnected.

In some embodiments, the connecting a battery pack to a switch module includes: sending a charge signal to a charge control module, so that the charge control module connects the battery pack to the switch module according to the charge signal. The charge control module can be controlled by the charge signal to connect the battery pack to the switch module, and whether the energy storage element is charged is determined according to the first detection voltage.

In some embodiments, the performing voltage detection on the energy storage element to obtain a first detection voltage includes: sending a first voltage detection signal to a voltage detection module when the battery pack is connected to the switch module; and receiving the first detection voltage obtained and sent by the voltage detection module after performing voltage detection on the energy storage element. By arranging the voltage detection module, when the battery pack is connected to the switch module, the voltage detection module is capable of being used to perform voltage detection on the energy storage element to obtain the first detection voltage. According to the first detection voltage, it can be determined whether the energy storage element is charged, and further determined whether an anomaly occurs in the disconnected state of the switch module.

In some embodiments, the charge control module includes at least two current branches; and the sending a first voltage detection signal to a voltage detection module includes: determining a first current branch connected between the battery pack and the switch module in the charge control module; and sending the first voltage detection signal to the voltage detection module so that the voltage detection module performs voltage detection on the energy storage element through a current branch other than the first current branch. The charge control module may include a plurality of current branches. The battery pack and the voltage detection module are connected to the switch module through different current branches, which is capable of preventing the voltage detection module from being affected by a charge current when performing voltage detection, thereby improving the accuracy of voltage detection.

In some embodiments, before the connecting a battery pack to a switch module when the switch module is disconnected, the method further includes: connecting a discharge module to the switch module when the switch module is turned on, so that the discharge module forms a first discharge loop with the energy storage element through the switch module; performing voltage detection on the energy storage element to obtain a second detection voltage; and sending a disconnect signal to the switch module when the second detection voltage reaches a safe voltage range. Before the switch module changes from turned-on to disconnected, the energy storage element can also be discharged through the discharge module to reduce a voltage across two ends of the energy storage element and reduce residual charges on the energy storage element.

In some embodiments, the performing voltage detection on the energy storage element to obtain a second detection voltage includes: determining a second current branch connected between the discharge module and the switch module in the charge control module; and sending a second voltage detection signal to the voltage detection module so that the voltage detection module performs voltage detection on the energy storage element through a current branch other than the second current branch. By arranging the voltage detection module and the discharge module to be connected to the energy storage element through different current branches respectively, the voltage detection module will not be affected by a discharge current of the energy storage element when performing voltage detection, thereby improving the accuracy of voltage detection.

In some embodiments, the determining, according to the first detection voltage, whether the switch module is completely disconnected includes: acquiring the safe voltage range; and controlling the battery pack to stop operating when the first detection voltage exceeds the safe voltage range. When the first detection voltage is too large, the battery pack may be controlled to stop operating, so as to avoid the battery pack from generating a large current during operation and causing damage to the energy storage element.

In a second aspect, an embodiment of the present application further provides a state detection circuit for a switch module, the circuit including: a switch module; an energy storage element, the energy storage element being connected to a first end of the switch module; and a control module, the control module being configured to connect a second end of the switch module to a battery pack when the switch module is disconnected, and to determine a disconnected state of the switch module according to a first detection voltage of the energy storage element. By connecting the battery pack to the switch module, it can be determined, according to the first detection voltage obtained by detection, whether the switch module is completely disconnected when the switch module is in the disconnected state. When the switch module is completely disconnected, the electrical apparatus can be switched to operate in a mode when the switch module is disconnected, thereby implementing a corresponding function. When the switch module is not completely disconnected, the electrical apparatus cannot be switched to operate in the mode when the switch module is disconnected.

In some embodiments, the circuit further includes: a charge control module connected between the switch module and the battery pack, the charge control module being configured to connect the battery pack to the switch module when receiving a charge signal.

In some embodiments, the circuit further includes: a voltage detection module electrically connected to the energy storage element, the voltage detection module being configured to, when receiving a first voltage detection signal, perform voltage detection on the energy storage element to obtain a first detection voltage, and/or, when receiving a second voltage detection signal, perform voltage detection on the energy storage element to obtain a second detection voltage.

In some embodiments, the charge control module includes at least two current branches, and the charge control module is configured to connect the battery pack to the switch module through a first current branch, and/or, connect a discharge module to the switch module through a second current branch. The voltage detection module is configured to, when receiving the first voltage detection signal, determine a third current branch from the plurality of current branches, and perform voltage detection on the energy storage element through the third current branch and the switch module, and/or, when receiving the second voltage detection signal, determine a fourth current branch from the plurality of current branches, and perform voltage detection on the energy storage element through the fourth current branch and the switch module.

In some embodiments, the charge control module includes a motor controller, the motor controller includes three bridge arm groups, and each of the bridge arm groups forms a current branch with the switch module.

In a third aspect, an embodiment of the present application further provides a state detection device for a switch module, the state detection device for a switch module including: a processor and a memory storing computer program instructions, wherein the computer program instructions, when executed by the processor, cause the state detection device for a switch module to implement the state detection method for a switch module in the above embodiment.

In a fourth aspect, an embodiment of the present application further provides a computer storage medium, wherein the computer storage medium stores computer program instructions, and the computer program instructions, when executed by a processor, implement the state detection method for a switch module in the above embodiment.

The above description is only an overview of the technical solution of the present application. In order to better understand the technical means of the present application and thus implement them according to the contents of the specification, and in order to make the aforementioned and other objectives, features, and advantages of the present application more obvious and understandable, detailed description of the present application will be made specifically below.

### BRIEF DESCRIPTION OF DRAWINGS

In order to explain technical solutions of the embodiments of the present application more clearly, a brief introduction of drawings to be used in the embodiments of the present application will be made below. Apparently, the drawings described below are merely some embodiments of the present application, and other drawings can be obtained according to these drawings by those skilled in the art without creative efforts.
FIG. 1 is a schematic flow chart of a state detection method for a switch module according to an embodiment of the present application;
FIG. 2 is a schematic diagram of a modular structure of a switch topology circuit according to an embodiment of the present application;
FIG. 3 is a schematic diagram of a modular structure of a switch topology circuit according to another embodiment of the present application;
FIG. 4 is a schematic diagram of a modular structure of a switch topology circuit according to still another embodiment of the present application;
FIG. 5 is a schematic diagram of a modular structure of a switch topology circuit according to yet another embodiment of the present application;
FIG. 6 is a schematic diagram of a modular structure of a switch topology circuit according to still another embodiment of the present application;
FIG. 7 is a schematic diagram of a circuit structure corresponding to the embodiment in FIG. 6;
FIG. 8 is a schematic diagram of a modular structure of a switch topology circuit according to yet another embodiment of the present application;
FIG. 9 is a schematic diagram of a circuit structure corresponding to the embodiment in FIG. 8; and
FIG. 10 is a schematic diagram of a structure of a state detection device for a switch module according to an embodiment of the present application.

In the accompanying drawings, the figures are not drawn to the actual scale.

In the accompanying drawings:
10. Battery pack; 20. Switch module; 30. DC charge port; 40. Motor controller; 50. Motor; 60. External charge device; 70. Heating module; K1. First switch; K2. Second switch; K3. Third switch; K4. Fourth switch; C. Energy storage element; C1. First capacitor; C2. Second capacitor.

### DETAILED DESCRIPTION

In order to make the objects, technical solutions and advantages of embodiments of the present application clearer, the technical solutions in the embodiments of the present application will be clearly described below with reference to the drawings for the embodiments of the present application. Apparently, the described embodiments are some of, rather than all of, the embodiments of the present application. All the other embodiments obtained by a person of ordinary skill in the art based on the embodiments of the present application without any creative effort shall fall within the scope of protection of the present application.

Unless otherwise defined, all technical and scientific terms used in the present application shall have the same meanings as those generally understood by those skilled in the art of the present application. The terms used in the present application in the specification of application are merely for the purpose of describing specific embodiments and are not intended to limit the present application. The terms "include" and "have" and any variations thereof in the specification and claims and the above brief description of the drawings of the present application are intended to cover non-exclusive inclusion. The terms "first," "second," etc. in the specification and the claims of the present application as well as the above drawings are used to distinguish different objects, rather than to describe a specific order or primary-secondary relationship.

The phrase "embodiment" referred to in the present application means that the descriptions of specific features, structures, and characteristics in combination with the embodiment are included in at least one embodiment of the present application. The appearance of this phrase in various places in the specification does not necessarily refer to the same embodiment, nor is it a separate or alternative embodiment that is mutually exclusive with other embodiments.

In the description of the present application, it should be noted that the terms "mounting," "connecting," "connection" and "attachment" should be understood in a broad sense, unless otherwise explicitly specified or defined, for example, it may be a fixed connection, a detachable connection or an integrated connection; and may be a direct connection or an indirect connection through an intermediate medium, or may be a communication between the interior of two elements. For those of ordinary skill in the art, the specific meanings of the above terms in the present application can be understood according to specific situations.

In the present application, the term "and/or" is only an association relation describing associated objects, which means that there may be three relations, for example, A and/or B may represent three situations: A exists alone, both A and B exist, and B exists alone. In addition, the character "/" in the present application generally means that the associated objects before and after it are in an "or" relationship.

In the embodiments of the present application, the same reference signs denote the same components, and for the sake of brevity, detailed descriptions of the same components are omitted in different embodiments. It should be understood that the thickness, length, width and other dimensions of the various components in the embodiments of the present application shown in the drawings, as well as the overall thickness, length, width and other dimensions of an integrated apparatus, are for illustrative purposes only, and should not constitute any limitation to the present application.

In the present application, the phrase "a plurality of" means two or more (including two).

At present, with the development of new energy technologies, batteries are increasingly widely applied in various electrical apparatuses, such as in mobile phones, notebook computers, battery cars, electric vehicles, electric airplanes, electric boats, and the like. With the continuous expansion of the application field of batteries, the market demand thereof is also constantly expanding.

Power batteries can serve as main power sources for electrical apparatuses (such as vehicles, ships, or spacecrafts), while energy storage batteries can serve as charging sources for electrical apparatuses. The importance of both is self-evident. As an example but not limitation, in some application scenarios, the power batteries may be batteries in electrical apparatuses, and the energy storage batteries may be batteries in charging apparatuses. For ease of description, in the following text, the power batteries and the energy storage batteries may be collectively referred to as batteries.

The batteries on the market are mostly rechargeable storage batteries, and the most common ones are lithium batteries, such as lithium-ion batteries or lithium-ion polymer batteries. When a battery is arranged in an electrical apparatus, if the remaining power of the battery is insufficient, it needs to be connected to a charging apparatus to charge the battery.

In a low temperature environment, since the temperature of a battery pack of an electric vehicle is lower than a temperature range required for its normal operation, the charging efficiency of the battery pack is relatively low at this point, and the charge device cannot effectively charge the battery pack. Therefore, under low-temperature conditions, the battery pack needs to be heated to a temperature range within which the battery pack is capable of operating normally before the battery pack can be charged normally through a charging pile.

With the continuous development of charge platforms for electric vehicles, high-voltage systems, such as 800 V high-voltage charge platforms, have been gradually popularized in existing electric vehicles. The charge devices deployed in the past are usually only low-voltage platforms, such as 400 V charging piles, because of deployment along time ago. For an electric vehicle on a high-voltage platform, when connected to a charge device on a low-voltage platform, even in a low-temperature environment, the electric vehicle is capable of heating a battery pack to a suitable temperature range by alternately charging and discharging the battery pack, but cannot be charged by the charge device on the low-voltage platform.

At present, in order to solve the problem of low efficiency of batteries under low-temperature conditions and the low voltage problem of charge devices, topology circuit design is usually carried out on original modules and components of electric vehicles. By adding new switch modules and energy storage components, switch control is used to achieve mode switching between an original function and a new function. However, when an anomaly occurs in the switch module, such as failure to be fully turned on or fully disconnected, electronic components of the electrical apparatus may be damaged.

In order to solve the aforementioned problem, an embodiment of the present application provides a state detection method, circuit, and device for a switch module, and a storage medium. The state detection method for a switch module provided in an embodiment of the present application is first introduced below.

The state detection method for a switch module disclosed in the embodiment of the present application can be used, but not limited to, in an electrical apparatus, such as a vehicle, a ship, or an aircraft. An embodiment of the present application provides an electrical apparatus that uses a battery pack as a power source. The electrical apparatus may include an energy storage element, a switch module, and a battery pack, and may also include other components with a state detection function for the switch module. The electrical apparatus may be, but is not limited to, a mobile phone, a tablet, a laptop, an electric toy, an electric tool, a battery car, an electric vehicle, a ship, a spacecraft, and the like.

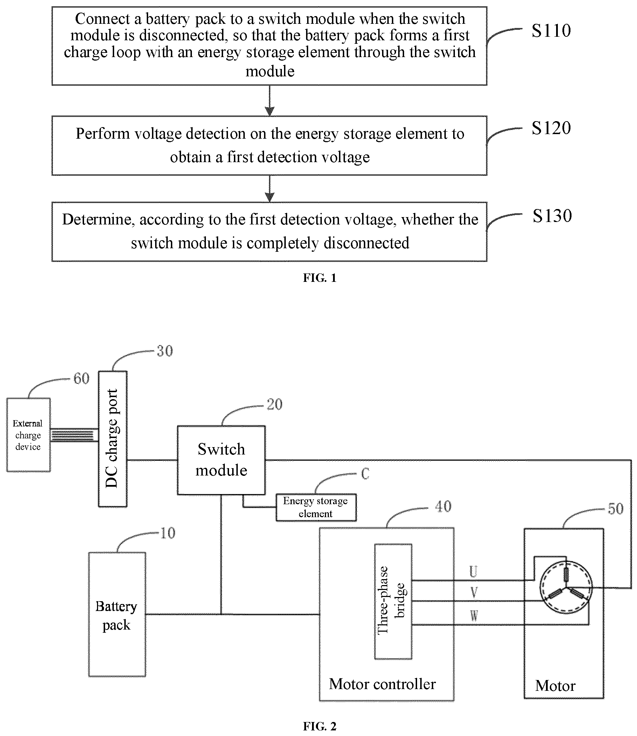

FIG. 1 is a schematic flow chart of steps of a state detection method for a switch module according to an embodiment of the present application. The state detection method for a switch module includes:
S110: Connect a battery pack to a switch module when the switch module is disconnected, so that the battery pack forms a first charge loop with an energy storage element through the switch module;
S120: Perform voltage detection on the energy storage element to obtain a first detection voltage; and
S130: Determine, according to the first detection voltage, whether the switch module is completely disconnected.

The above status detection method for a switch module may be applied to an electrical apparatus provided with a switch module, and the electrical apparatus may include the switch module, an energy storage element, a battery pack, and the like. The switch module may be connected between the energy storage element and the battery pack. By controlling on-off of the switch module, the electrical apparatus is capable of being switched between different modes to achieve different functions. For example, when the switch module is turned on, the battery pack is capable of being electrically connected to the energy storage element. At this point, the electrical apparatus is capable of being combined with other components through the battery pack and the energy storage element to achieve a corresponding function. When the switch module is disconnected, the battery pack is disconnected from the energy storage element. At this point, the electrical apparatus can achieve another part of functions through the battery pack, such as a charging function or discharging function of the battery pack.

In S110, the battery pack may be connected to the switch module when the switch module is disconnected, so that the battery pack forms the first charge loop with the energy storage element through the switch module.

It is understandable that when the switch module is turned on, the battery pack is capable of being electrically connected to the energy storage element through the switch module and charging the energy storage element. When the switch module is disconnected, the battery pack cannot be electrically connected to the energy storage element, and cannot charge the energy storage element. That is, when the switch module is disconnected, the first charge loop is in a disconnected state, and the battery pack cannot charge the energy storage element. When the switch module is not disconnected, the first charge loop is in an on state, and at this point, the battery pack is capable of charging the energy storage element.

When the switch module is disconnected, the battery pack is connected to the switch module. If the switch module is fully disconnected, the battery pack cannot charge the energy storage element. If the switch module is not fully disconnected, it is equivalent to the switch module being in the on state, and at this point, the battery pack is capable of charging the energy storage element. That is, whether the switch module is fully disconnected can be determined according to whether the energy storage element is charged.

When the switch module switches between the on state and the disconnected state, if the disconnected state of the switch module is not complete, that is, the switch module is not completely disconnected, the battery pack is still capable of being connected to the energy storage element through the switch module that is not completely disconnected. At this point, if the electrical apparatus is switched to a functional mode that is capable of being realized when the switch module is disconnected, a battery voltage output by the battery pack is likely to cause damage to the energy storage element. For example, when the switch module is a relay, if a contact of the relay is sintered, the relay cannot be completely disconnected, and the battery pack is capable of continuing to be connected to the energy storage element through the relay. In this state, if the electrical apparatus is switched to the mode when the switch module is disconnected and continues operating, the energy storage element may be damaged. Therefore, when the switch module is disconnected, it is necessary to detect the disconnected state of the switch module to determine whether the switch module is completely disconnected.

When the battery pack is connected to the switch module, if the switch module is completely disconnected, the battery pack is not connected to the energy storage element, and if the switch module is not completely disconnected, the battery pack is capable of being connected to the energy storage element through the switch module.

In S120, when the battery pack and the switch module are turned on, voltage detection may be performed on the energy storage element to obtain the first detection voltage.

If the disconnected state of the switch module is completely disconnected, the battery pack cannot be electrically connected to the energy storage element. If the disconnected state of the switch module is not completely disconnected, the battery pack is capable of continuing to be electrically connected to the energy storage element through the partially turned-on switch module. When the battery pack is electrically connected to the energy storage element, the battery pack is capable of discharging to charge the energy storage element, so that the voltage of the energy storage element increases. That is, according to whether the detected first detection voltage is relatively high, it can be determined whether the battery pack charges the energy storage element, and it is further determined whether the switch module is completely disconnected or not completely disconnected.

In S130, after the first detection voltage is acquired, it can be determined, according to the first detection voltage, whether the switch module is completely disconnected, that is, whether the energy storage element is connected to the battery pack when the switch module is disconnected.

If the switch module is capable of being completely disconnected, when the battery pack is connected to the switch module, the first charge loop is not turned on and the battery pack will not charge the energy storage element. If the switch module is not completely disconnected, the first charge loop is turned on, and the battery pack charges the energy storage element.

According to the above analysis, after the first detection voltage is obtained, it can be determined, according to the magnitude of the first detection voltage, whether the battery pack charges the energy storage element. If it is determined that the energy storage element is not charged, it can be determined that the disconnected state of the switch module is completely disconnected. If it is determined that the energy storage element is charged, it can be determined that an anomaly occurs in the disconnected state of the switch module. The anomaly of the disconnected state may be that the switch module remains in the on state, or the switch module is in a partially on state.

It should be noted that when voltage detection is performed on the energy storage element, the module for voltage detection may be directly electrically connected to the energy storage element, or may be electrically connected to the energy storage element through the switch module.

When the module for voltage detection is directly electrically connected to the energy storage element, the voltage across two ends of the energy storage element can be directly detected regardless of whether the switch module is disconnected. That is, when the switch module is disconnected, the voltage detected is a voltage when the energy storage element is not charged. When the switch module is not completely disconnected, the voltage detected is a voltage when the energy storage element is charged.

When the module for voltage detection is electrically connected to the energy storage element through the switch module, the module is capable of detecting the voltage across two ends of the energy storage element only when the switch module is not disconnected. That is, when the switch module is not completely disconnected, the voltage detected is the voltage when the energy storage element is charged. When the switch module is completely disconnected, the voltage detected should actually be a battery voltage of the battery pack.

In the above two methods of connecting the module for voltage detection to the energy storage element, the voltage detected when the switch module is not completely disconnected is different from the voltage detected when the switch module is completely disconnected. Therefore, both of the above two connection methods are capable of determining, according to the first detection voltage obtained by detection, whether the switch module is completely disconnected, thereby determining whether an anomaly occurs in the disconnected state of the switch module.

It is understandable that when it is determined that the switch module is completely disconnected, the electrical apparatus can be switched to the mode when the switch module is disconnected and implement the corresponding function. At this point, the energy storage element is not connected to the battery pack, and the energy storage element will not be damaged when the electrical apparatus operates in this mode. When it is determined that the switch module is not completely disconnected, in order to avoid damage to the energy storage element after mode switching, the electrical apparatus cannot be switched to operate in the mode when the switch module is disconnected.

In this embodiment, by connecting the battery pack to the switch module, it can be determined whether the switch module is completely disconnected when the switch module is in the disconnected state. If the switch module is not completely disconnected, the battery pack is capable of charging the energy storage element through the switch module, so that the first detection voltage obtained by detection is large. If the switch module is completely disconnected, the battery pack cannot charge the energy storage element, so that the first detection voltage obtained by detection is small. Whether the switch module is in a completely disconnected state when it is disconnected can be determined according to the magnitude of the first detection voltage. When the switch module is completely disconnected, the electrical apparatus can be switched to operate in a mode when the switch module is disconnected, thereby implementing a corresponding function. When the switch module is not completely disconnected, the electrical apparatus cannot be switched to operate in the mode when the switch module is disconnected.

It should be noted that when determining, according to the first detection voltage, whether the switch module is completely disconnected, corresponding response and processing may also be performed according to the determination result. For example, when the switch module fails to be completely disconnected, switching to the mode when the switch module is disconnected may be stopped, and an alarm prompt may be issued to a user to remind the user that an anomaly occurs in the switch module and the energy storage element is not completely disconnected from the battery pack, thereby allowing the user or relevant personnel to maintain and repair the switch module.

According to some embodiments of the present application, the above S110 may further include:
S210: Send a charge signal to a charge control module, so that the charge control module connects the battery pack to the switch module according to the charge signal.

In S210, the electrical apparatus may further include a charge control module, and the charge control module may be connected between the battery pack and the switch module. The charge control module can connect the battery pack to the switch module or disconnect the battery pack from the switch module. When the apparatus sends the charge signal to the charge control module, the charge control module can connect the battery pack to the switch module.

The charge control module may be a control component connected to the battery pack in the electrical apparatus. The control component may be an existing one in the electrical apparatus, or a newly added control component for realizing the connection between the switch module and the battery pack.

Taking the electrical apparatus being an electric vehicle, an electric ship, an electric airplane, and another device that includes a motor controller and a motor as an example, the motor controller is connected between the motor and the battery pack. The motor controller is not only capable of realizing battery voltage conversion of the battery pack, but also capable of controlling connection and disconnection between the battery pack and the motor. Therefore, the charge control module may be a motor controller in the electrical apparatus. By connecting two ends of a switch component in the motor controller to the battery pack and the switch module respectively, the motor controller can be used as the charge control module to control on and off of the switch component under the control of the charge signal, thereby realizing the connection and disconnection between the battery pack and the switch module.

It is understandable that since the motor controller needs to perform voltage conversion, such as inverter conversion and voltage regulation conversion, on the battery voltage of the battery pack in the electrical apparatus, components in the motor controller that are electrically connected to the battery pack need to meet requirements of operating at a high battery voltage. That is, the components in the motor controller that are electrically connected to the battery pack should be components that are capable of operating normally under high voltage and high current. When the motor controller is used as the charge control module, even if a charge current when the battery pack charges the energy storage element is high, no damage will be caused to the components in the motor controller that connect the battery pack to the switch module, thereby achieving stable connection between the battery pack and the energy storage element.

As an optional implementation, the charge control module may also be a battery management system (BMS).

In the electrical apparatus including the battery pack, a battery management system connected to the battery pack is usually provided. The battery management system is capable of realizing functions such as charge and discharge control of the battery pack and state detection and parameter detection of the battery pack. When the battery management system performs the charge and discharge control on the battery pack, it needs to control the on and off states of the battery pack and an external device, for example, connect or disconnect the battery pack to/from the external device through a charge and discharge switch component. The battery management system is used as the charge control module, and the battery management system can determine the switch component connected between the battery pack and the switch module when receiving a charge signal, and control the switch component to be turned on, so as to connect the battery pack to the switch module.

The charge control module may also be another module, another switch component, or the like connected between the battery pack and the switch module in the electrical apparatus. By reusing the original module or component in the electrical apparatus as the charge control module, it is capable of avoiding arranging an additional switch component and reduce component costs.

It is understandable that the battery pack can be electrically connected to the energy storage element through the charge control module and the switch module. When the charge control module and the switch module are both in the on state, a charge loop can be formed between the battery pack and the energy storage element to charge the energy storage element. When the charge control module is turned on, if the switch module is disconnected, the energy storage element is not capable of being charged, and if the switch module is not completely disconnected, the energy storage element is capable of being charged. When the charge control module is controlled by the charge signal to be turned on, whether an anomaly occurs in the disconnected state of the switch module can be determined according to whether the energy storage element is charged.

In this embodiment, by sending the charge signal to the charge control module, the charge control module can be controlled to connect the battery pack to the switch module, and whether the energy storage element is charged is determined according to the first detection voltage. If the energy storage element is not charged, it can be determined that the switch module is stably disconnected and no anomaly occurs in the disconnected state. If the energy storage element is charged, it can be determined that an anomaly occurs in the disconnected state of the switch module, that is, the switch module is not completely disconnected.

According to some embodiments of the present application, the above S120 may further include:
S310: Send a first voltage detection signal to a voltage detection module when the battery pack is connected to the switch module; and
S320: Receive a first detection voltage obtained and sent by the voltage detection module after performing voltage detection on the energy storage element.

In S310, the electrical apparatus may further include the voltage detection module, and the voltage detection module may be electrically connected to the energy storage element to detect the voltage across two ends of the energy storage element.

When the battery pack is connected to the switch module, the apparatus can send the first voltage detection signal to the voltage detection module, so that the voltage detection module detects the voltage across two ends of the energy storage element.

In S320, when the battery pack is connected to the switch module, voltage detection may be performed on the energy storage element through the voltage detection module, and the first detection voltage obtained by detection of the voltage detection module can be acquired.

It is understandable that when the battery pack is connected to the switch module, the first detection voltage may be a voltage value that can be obtained by detection of the voltage detection module after the battery pack is connected to the switch module for a period of time. The first detection voltage may also be a plurality of voltage values obtained by periodically performing voltage detection by the voltage detection module when the battery pack is connected to the switch module.

The voltage detection module may be a voltage divider circuit, an optocoupler isolation circuit, a voltage detection chip, a voltmeter, an operational amplifier circuit, or another circuit or component capable of realizing voltage detection. Taking a voltage divider circuit as an example, an input end of the voltage divider circuit may be electrically connected to the energy storage element, and an output end may be connected to a voltage detection port. The voltage divider circuit can divide the voltage across two ends of the energy storage element and send the first detection voltage after voltage division to a processing module of the electrical apparatus, so that the processing module determines the disconnected state of the switch module according to the first detection voltage. It is understandable that the voltage divider circuit may step down the higher voltage across two ends of the energy storage element to obtain the smaller first detection voltage, thereby preventing the first detection voltage from being too high and causing damage to the components in the circuit, thereby improving the safety of voltage detection. Similarly, setting the voltage detection module as an operational amplifier circuit can also amplify or reduce the voltage across two ends of the energy storage element, so as to adjust the output first detection voltage to be within a suitable voltage range.

When the voltage detection module is an optocoupler isolation circuit, an input side is electrically connected to the energy storage element, and an output side is connected to the processing module of the electrical apparatus. According to the voltage across two ends of the energy storage element detected on the input side, a light-emitting state of a light-emitting element on the input side may be adjusted, and the processing module is capable of receiving corresponding high-level and low-level signals from the output side when the light-emitting element emits light and does not emit light, and determining, according to the high-level and low-level signals, whether the energy storage element is charged. Through optocoupler isolation, the voltage signals on the input side and the output side are capable of being isolated to avoid mutual interference between the voltage signals on both sides of the optocoupler isolation module.

The voltage detection module may also be a voltage detection chip, a voltmeter, or the like. The voltage detection chip has a detection end electrically connected to the energy storage element, and an output end connected to the processing module of the electrical apparatus, and can perform voltage detection on the energy storage element and transmit the detected voltage signal to the processing module.

In this embodiment, by arranging the voltage detection module, when the battery pack is connected to the switch module, the voltage detection module is capable of being controlled by the first voltage detection signal to perform voltage detection on the energy storage element to obtain the first detection voltage. According to the first detection voltage, it can be determined whether the energy storage element is charged, and further determined whether an anomaly occurs in the disconnected state of the switch module.

According to some embodiments of the present application, the charge control module includes at least two current branches, and the above S310 may further include:
S410: Determine a first current branch connected between the battery pack and the switch module in the charge control module; and
S420: Send the first voltage detection signal to the voltage detection module, so that the voltage detection module performs voltage detection on the energy storage element through a current branch other than the first current branch.

In S410, the charge control module may include at least two current branches, and each of the current branches is capable of independently realizing the connection between the switch module and the battery pack. When the charge control module connects the battery pack to the switch module, it may be determined that a current branch corresponding to the connection between the battery pack and the switch module realized by the charge control module is the first current branch.

In S420, after determining the first current branch, the apparatus may generate the first voltage detection signal and send it to the voltage detection module. After receiving the first voltage detection signal, the voltage detection module may be connected to the switch module through a current branch other than the first current branch in the charge control module, and then electrically connected to the energy storage element through the switch module to realize voltage detection for the energy storage element.

Among the plurality of current branches of the charge control module, the current branch connecting the battery pack to the switch module and the current branch for performing voltage detection are different from each other, which is capable of reducing the mutual interference between a charge process of the battery pack to the energy storage element and a voltage detection process of the voltage detection module, thereby improving the voltage detection accuracy of the voltage detection module.

It is understandable that when the voltage detection module performs voltage detection through a current branch of the charge control module, the voltage detection module is electrically connected to the energy storage element through the charge control module. If the switch module is completely disconnected, the charge control module and the energy storage element are in a disconnected state, and at this point, the voltage detection module cannot detect the voltage across two ends of the energy storage element. For example, taking the plurality of current branches of the charge control module having a common intersection as an example, when the switch module is disconnected, the voltage detection module may be connected to the first current branch through the common intersection of the plurality of current branches. When the first current branch is electrically connected to the battery pack, the voltage value detected by the voltage detection module is the battery voltage of the battery pack.

In this embodiment, the charge control module may include a plurality of current branches, and the battery pack may be connected to the switch module through one of the current branches to charge the energy storage element. The voltage detection module may be connected to the switch module through another current branch to perform voltage detection on the energy storage element. The battery pack and the voltage detection module are connected to the switch module through different current branches, which is capable of preventing the voltage detection module from being affected by a charge current when performing voltage detection, thereby improving the accuracy of voltage detection.

According to some embodiments of the present application, before the above S110, the method may further include:
S510: Connect the discharge module to the switch module when the switch module is turned on, so that the discharge module forms a first discharge loop with the energy storage element through the switch module;
S520: Perform voltage detection on the energy storage element to obtain a second detection voltage; and
S530: Send a disconnect signal to the switch module when the second detection voltage reaches a safe voltage range.

The switch module can be switched between an on state and a disconnected state, so that the electrical apparatus is capable of being switched between different modes and realizing corresponding functions. When the switch module is turned on, the energy storage element is capable of being electrically connected to the battery pack. At this point, whether the battery pack is charged or the battery pack is discharged, the energy storage element will store a certain amount of charges during the operation of the electrical apparatus. The stored charges will cause the voltage across two ends of the energy storage element to increase. In order to prevent the voltage across two ends of the energy storage element from being too high, when the switch module changes from the on state to be disconnected, the charges of the energy storage element may be discharged to reduce the voltage across two ends of the energy storage element.

In S510, when the switch module is turned on, the discharge module may be connected to the switch module, and the discharge module may be electrically connected to the energy storage element through the turned-on switch module to form a first discharge loop. The energy storage element may discharge the discharge module through the first discharge loop to achieve charge discharge of the energy storage element.

In S520, when the energy storage element is discharged through the discharge module, voltage detection may also be performed on the energy storage element. When the electrical apparatus includes the voltage detection module, the voltage across two ends of the energy storage element may be detected by the voltage detection module to obtain the second detection voltage. In another implementation, the electrical apparatus may also perform voltage detection on the energy storage element by using another voltage detection assembly.

In S530, after the second detection voltage is acquired, the second detection voltage may be compared with a safe voltage range. When the second detection voltage exceeds the safe voltage range, it indicates that there are still a lot of residual charges on the energy storage element. At this point, the energy storage element may continue to be discharged through the discharge module. When the second detection voltage is within the safe voltage range, it may be determined that there are few residual charges on the energy storage element. At this point, a disconnect signal may be sent to the switch module to change the switch module from the on state to the disconnected state.

The above discharge module may be a discharge component, discharge assembly, and the like that is capable of discharging the energy storage element, such as an inductor, a resistor, a coil, and a capacitor. The discharge component may be an existing component in the electrical apparatus, or a newly added discharge component for realizing the discharge of the energy storage element.

Taking the electrical apparatus being a device including a motor controller and a motor as an example, the discharge module may be the motor of the electrical apparatus, and the motor may be a three-phase motor or a single-phase motor. Taking a three-phase motor as an example, each of the phases of the motor is provided with a corresponding winding inductor. When the winding inductor is connected to the energy storage element, it is capable of converting electrical energy released by the energy storage element into thermal energy, thereby discharging the energy storage element. When the motor is a three-phase motor, the motor controller may be a three-phase bridge. By controlling a bridge arm group of at least one phase to be turned on, a winding inductor corresponding to the bridge arm group may be connected to the energy storage element through the switch module, thereby realizing discharge of the energy storage element. Furthermore, using the motor as the discharge module to discharge the energy storage element through the winding inductor does not need to additionally arrange a discharge component, and is further capable of reducing the size and cost of the apparatus.

As an optional implementation, the above discharge module may also be another module or another assembly having a capacitor, a resistor, an inductor, or a coil in the electrical apparatus. Reusing the original component in the electrical apparatus as the discharge module without additionally arranging a new discharge module is further capable of reducing the size and cost of the apparatus.

In this embodiment, before changing from turned-on to disconnected, the switch module may further be electrically connected to the energy storage element through the discharge module, so that the energy storage element discharges through the discharge module to reduce the voltage across two ends of the energy storage element. According to the second detection voltage obtained by detection, the switch module may be changed into the disconnected state after the energy storage element is fully discharged, thereby reducing the residual charges on the energy storage element and lowering the voltage across two ends of the energy storage element.

According to some embodiments of the present application, before the above S520, the method may further include:
S610: Determine a second current branch connected between the discharge module and the switch module in the charge control module; and
S620: Send a second voltage detection signal to the voltage detection module, so that the voltage detection module performs voltage detection on the energy storage element through a current branch other than the second current branch.

In S610, the charge control module may be the charge control module having a plurality of current branches in the above embodiment. When the discharge module is electrically connected to the switch module through the charge control module, a current branch connected between the discharge module and the switch module may be determined, and the current branch is the second current branch.

In S620, after determining the second current branch connecting the discharge module to the energy storage element, the apparatus may send the second voltage detection signal to the voltage detection module. The voltage detection module may determine the second current branch according to the second voltage detection signal, and may be connected to the switch module through a current branch other than the second current branch, so as to perform voltage detection on the energy storage element through the turned-on switch module.

It is understandable that when the discharge module discharges the energy storage element, a certain discharge current will be generated in the discharge loop. If the voltage detection module is electrically connected to the energy storage element through the current branch, a voltage value detected by the voltage detection module will be affected by the discharge current and deviate from the actual voltage of the energy storage element. In order to avoid the influence of the discharge current on the detected voltage value, the discharge of the energy storage element and the voltage detection of the energy storage element may be achieved through two current branches respectively.

In this embodiment, when the discharge module is connected to the energy storage element through the switch module and discharges the energy storage element, the voltage detection module may detect the voltage of the energy storage element and determine, according to the second detection voltage obtained by detection, whether to end the discharge process. During the discharge of the energy storage element, when the charge control module includes a plurality of current branches, the voltage detection module and the discharge module are connected to the energy storage element through different current branches, respectively, so that the voltage detection module will not be affected by the discharge current of the energy storage element during voltage detection, thereby improving the accuracy of voltage detection.

According to some embodiments of the present application, after the discharge module discharges the energy storage element through the second current branch, the apparatus may control the switch module to be disconnected, and connect the switch module to the battery pack through the first current branch. The first current branch and the second current branch may be different current branches of the charge control module. That is, the discharge process and the charge process of the energy storage element are connected to different current branches, respectively. When the battery pack is connected to the switch module, the battery pack will not be connected to the discharge module, so that the charge process of the battery pack to the energy storage element will not be affected by the discharge module.

According to some embodiments of the present application, the above S130 may further include:
S710: Acquire a safe voltage range; and
S720: Control the battery pack to stop operating when the first detection voltage exceeds the safe voltage range.

In S710, the apparatus may obtain a preset safe voltage range.

It is understandable that when the energy storage element is electrically connected to the battery pack, the battery pack charging the energy storage element will cause the voltage across two ends of the energy storage element to increase. In order to be capable of identifying, through the safe voltage range, whether the energy storage element is charged, the safe voltage range should be a voltage range of the energy storage element when it is not charged. That is, when the energy storage element is not electrically connected to the battery pack, the voltage across two ends thereof should always be within the safe voltage range.

The above safe voltage range may be 0 V to 60 V. That is, when the energy storage element is not being charged, the voltage across two ends thereof should be within 60 V

Taking the safe voltage range being within 60 V as an example, when the energy storage element is discharged through the discharge module, the voltage across two ends of the energy storage element should be reduced to be within 60 V through the discharge process. That is, voltage detection may be performed on the energy storage element in the discharge process, and when the detected second detection voltage is lower than 60 V, the discharge process may be ended.

In S720, the apparatus may compare the first detection voltage with the safe voltage range. When the first detection voltage is within the safe voltage range, it may be determined that the energy storage element is not charged, the battery pack is not electrically connected to the energy storage element, and the switch module is in a completely disconnected state. When the first detection voltage exceeds the safe voltage range, it may be determined that the battery pack charges the energy storage element and the switch module has not been completely disconnected. That is, an anomaly occurs in the disconnected state of the switch module.

After it is determined that the switch module is completely disconnected, the electrical apparatus can be switched to operate in the mode when the switch module is disconnected. When it is determined that the switch module is not completely disconnected, since the energy storage element can still be connected to the battery pack through the switch module, in order to avoid damage to the energy storage element or another component during the operation of the electrical apparatus, the electrical apparatus cannot be switched to operate in the mode when the switch module is disconnected. At this point, the apparatus may control the battery pack to stop operating, for example, control the battery pack to stop charging or discharging. It is understandable that the apparatus controls the battery pack to stop operating by sending a corresponding instruction to the battery management system of the battery pack to cause the battery management system to disconnect the battery pack from the external component; or by sending a disconnect signal to a switch component connected between the battery pack and another circuit to disconnect the battery pack from the other circuit.

An embodiment of the present application further provides a state detection circuit for a switch module. The state detection circuit for a switch module may be applied to an electrical apparatus. The state detection circuit for a switch module includes a switch module, an energy storage element, and a control module.

A first end of the switch module is connected to the energy storage element, and a second end of the switch module can be switched between connection and disconnection to/from the battery pack.

When the switch module is disconnected, the control module may connect the second end of the switch module to the battery pack and perform voltage detection on the energy storage element to obtain a first detection voltage.

The first end of the switch module is connected to the energy storage element, and the second end is connected to the battery pack. When the switch module is disconnected, if the switch module is completely disconnected, the energy storage element is not connected to the battery pack, and the battery pack cannot charge the energy storage element. If the switch module is not completely disconnected, the energy storage element is capable of being electrically connected to the battery pack through the switch module, and the battery pack is capable of charging the energy storage element, so that the voltage across two ends of the energy storage element increases. The control module may determine, according to the first detection voltage, whether the energy storage element is undergoing a charge process, thereby determining whether the switch module is in a completely disconnected state.

In this embodiment, by connecting the battery pack to the switch module, it can be determined whether the switch module is completely disconnected when the switch module is in the disconnected state. If the switch module is not completely disconnected, the battery pack is capable of charging the energy storage element through the switch module, so that the first detection voltage obtained by detection is large. If the switch module is completely disconnected, the battery pack cannot charge the energy storage element, so that the first detection voltage obtained by detection is small. Whether the switch module is in a completely disconnected state when it is disconnected can be determined according to the magnitude of the first detection voltage. When the switch module is completely disconnected, the electrical apparatus can be switched to operate in a mode when the switch module is disconnected, thereby implementing a corresponding function. When the switch module is not completely disconnected, the electrical apparatus cannot be switched to operate in the mode when the switch module is disconnected.

According to some embodiments of the present application, the state detection circuit for a switch module may further include a charge control module. The charge control module is connected between the switch module and the battery pack.

The control module may send a charge signal to the charge control module, and the charge control module may connect the battery pack to the switch module when receiving a charge signal. After the two ends of the switch module are connected to the battery pack and the energy storage element, respectively, if the switch module is completely disconnected, the voltage across two ends of the energy storage element will not increase, and if the switch module is not completely disconnected, the battery pack will charge the energy storage element, which will cause the voltage across two ends of the energy storage element to increase. The disconnected state of the switch module may be determined according to the first detection voltage of the energy storage element.

In this embodiment, by sending the charge signal to the charge control module, the charge control module can be controlled to connect the battery pack to the switch module, and whether the energy storage element is charged is determined according to the first detection voltage. If the energy storage element is not charged, it can be determined that the switch module is stably disconnected and no anomaly occurs in the disconnected state. If the energy storage element is charged, it can be determined that an anomaly occurs in the disconnected state of the switch module, that is, the switch module is not completely disconnected.

According to some embodiments of the present application, the state detection circuit for a switch module may further include a voltage detection module.

The voltage detection module may be electrically connected to the energy storage element, and the control module may send the first voltage detection signal or a second voltage detection signal to the voltage detection module.

When receiving the first voltage detection signal, the voltage detection module may perform voltage detection on the energy storage element to obtain the first detection voltage. When receiving the second voltage detection signal, the voltage detection module may perform voltage detection on the energy storage element to obtain a second detection voltage.

According to the above embodiment of the state detection method for a switch module, it may be determined that when the energy storage element is discharged through the discharge module, the control module may send the second voltage detection signal, and the second detection voltage detected by the voltage detection module according to the second voltage detection signal is the voltage of the energy storage element in the discharge process. When the energy storage element is charged through the battery pack, the control module may send the first voltage detection signal. The voltage detection module may determine, according to the first detection voltage detected by the first voltage detection signal, whether the energy storage element is charged, and then determine whether the switch module is in a completely disconnected state when in the disconnected state.

In this embodiment, the voltage detection module may perform voltage detection on the energy storage element according to the corresponding voltage detection signal. According to the first detection voltage, it may be determined whether the energy storage element is charged, and further determined whether the switch module is in a completely disconnected state when in the disconnected state. According to the second detection voltage, it may be determined whether the voltage across two ends of the energy storage element is reduced to within a safe voltage range, and the discharge process is terminated.

According to some embodiments of the present application, the above charge control module includes at least two current branches.

When connecting the battery pack to the switch module, the charge control module may connect the battery pack to the switch module through a first current branch among a plurality of current branches.

When connecting the discharge module to the switch module, the charge control module may connect the discharge module to the switch module through a second current branch among the plurality of current branches.

When receiving the first voltage detection signal, the voltage detection module may determine a third current branch from the plurality of current branches, where the third current branch is not the same as the first current branch. That is, the voltage detection module may select a current branch other than the first current branch from the plurality of current branches to perform voltage detection.

It is understandable that in the process of the battery pack charging the energy storage element, a certain charge current will be generated. When the voltage detection module performs voltage detection through the same current branch, an obtained detection value will be affected by the charge current. By setting different current branches to respectively realize charging and voltage detection, the accuracy of voltage detection may be improved.

When receiving the second voltage detection signal, the voltage detection module may determine a fourth current branch from the plurality of current branches, where the fourth current branch is not the same as the second current branch. That is, the voltage detection module may select a current branch other than the second current branch from the plurality of current branches to perform voltage detection.

It is understandable that in the process of the discharge module discharging the energy storage element, a certain discharge current will be generated. When the voltage detection module performs voltage detection through the same current branch, an obtained detection value will be affected by the discharge current. By setting different current branches to respectively realize discharging and voltage detection, the accuracy of voltage detection may be improved.

In the above embodiment, the first current branch and the second current branch may be different current branches. When the discharge module discharges the energy storage element through the second current branch, the discharge module may also store a certain amount of residual charges. If the battery pack charges the energy storage element through the current branch during discharge, the charge process will be affected by the discharge module. By setting different current branches for the discharge and charge processes, it is capable of avoiding the discharge module and the current branch in which it is located from affecting the charge process.

According to some embodiments of the present application, when the electrical apparatus is an apparatus having a motor controller and a motor, such as an electric vehicle, an electric ship, or an electric airplane, the charge control module may include the motor controller, and the discharge module may include the motor.

The motor controller may include a three-phase bridge, and the three-phase bridge includes three bridge arm groups. Each of the bridge arm groups may be connected to a switch module, respectively, to form a current branch. That is, the motor controller may include three current branches.

The motor may include winding inductors respectively connected to the three bridge arm groups. When a single bridge arm group is connected to the switch module, the corresponding winding inductor may be used as the discharge module to discharge the energy storage element, so as to reduce the voltage across two ends of the energy storage element.

It is understandable that when the electrical apparatus is an electric vehicle, the motor controller may be a three-phase bridge. When the electrical apparatus is another electronic device, the motor controller may also be a single-phase bridge. It is understandable that the single-phase bridge includes two bridge arm groups, that is, the single-phase bridge includes two current branches. When the motor controller is a single-phase bridge, the motor may be an AC drive motor.

Taking the electric vehicle as an example, the switch module is switched to a disconnected state in order to be switched to operate in a motor drive mode or torque mode, so as to drive, with the battery voltage output by the battery pack, the motor to operate, thereby providing traveling power for the electric vehicle. If it is determined according to the first detection voltage that the switch module is not completely disconnected, the electric vehicle cannot be switched to the motor drive mode or the torque mode for operation. That is, the electric vehicle cannot enter a traveling state.

According to some embodiments of the present application, the charge control module may further be a switch component that is arranged in the electrical apparatus and connected to the battery pack. For example, a positive port and a negative port of the battery pack may be connected to an external component via a Metal-Oxide-Semiconductor Field-Effect Transistor (MOSFET) or other types of transistors, and the charge control module may include a MOSFET or other transistors. A battery management system of the battery pack may control the on and off between the battery pack and a load, a charge device, or the energy storage element, and therefore, the above charge control module may also be the battery management system.

According to some embodiments of the present application, the above discharge module may further be a discharge component, discharge assembly, and the like that is capable of discharging the energy storage element, such as an inductor, a resistor, a coil, and a capacitor. When the switch module is turned on, the energy storage element may be electrically connected to the discharge component, and the charges are discharged through the discharge component, so as to reduce the voltage across two ends of the energy storage element.

An embodiment of the present application further provides a switch topology circuit. The above state detection method for a switch module may be applied to the switch topology circuit in the following embodiment. As shown in FIG. 2, the switch topology circuit may be applied to an electrical apparatus, and the electrical apparatus includes a motor controller 40, a motor 50, and a battery pack 10. The switch topology circuit includes a DC charge port 30, an energy storage element C, and a switch module 20.

The DC charge port 30 is capable of being connected to an external charge device 60. When the external charge device 60 is connected, the DC charge port 30 may receive a charge voltage provided by the external charge device 60. The battery pack 10 is connected to the motor controller 40, and the motor controller 40 is connected to the motor 50.

The switch module 20 includes a first end, a second end, and a third end. The first end of the switch module 20 is connected to the DC charge port 30, the second end is connected to the battery pack 10, and the third end is connected to a neutral point of the motor 50.

The switch module 20 may connect various ports. The energy storage element C is connected between the first end and the third end of the switch module 20. That is, when the first end of the switch module 20 is turned on, the energy storage element C is connected to the DC charge port 30. When the third end of the switch module 20 is turned on, the energy storage element C is connected to the neutral point of the motor 50.

When the switch module 20 connects its first end to the third end, the energy storage element C, the motor controller 40, the motor 50, and the switch module 20 are capable of forming a boost current loop. The boost current loop is capable of receiving, through the DC charge port 30, a charge voltage output by the external charge device 60, and after boosting the charge voltage, outputting it to the battery pack 10, so as to charge the battery pack 10 with the boosted charge voltage.

When the switch module 20 turns on the third end, the neutral point of the motor 50 on both sides of the third end is capable of being connected to the energy storage element C. At this point, the energy storage element C, the motor controller 40, the motor 50, and the switch module 20 are capable of forming a heating current loop. The heating current loop is capable of alternately charging and discharging between the battery pack 10 and the energy storage element C to form an oscillation circuit. During the charge and discharge cycle, when an oscillating current flows through the battery pack 10, the internal resistance of the battery pack 10 generates ohmic heat under the drive of the current, thereby heating the battery pack 10.

When the electrical apparatus is an electric vehicle, in order to be capable of driving the motor 50 of the electric vehicle to achieve vehicle traveling, the battery pack 10 may be electrically connected to the motor controller 40, and the motor controller 40 is electrically connected to the motor 50. The battery pack 10 may output a DC voltage to the motor controller 40, and the motor controller 40 may perform DC-AC conversion on the DC voltage to generate a three-phase AC voltage, and input the three-phase AC voltage to a three-phase input end of the motor 50. The motor 50 is driven by the three-phase AC voltage to achieve vehicle traveling.

By controlling the connection between various ends, the switch module 20 can realize switching of the electrical apparatus between different modes. Taking the electrical apparatus being an electric vehicle as an example, the electric vehicle can realize switching between a motor drive mode, a DC charge mode, a boost charge mode, and a battery pack heating mode.

In the motor drive mode, the first end, the second end, and the third end of the switch module 20 are disconnected from each other. At this point, the battery pack 10, the motor controller 40, and the motor 50 constitute a motor drive circuit. The battery pack 10 is capable of providing a DC voltage. After converting the DC voltage into a three-phase AC voltage, the motor controller 40 may output the three-phase AC voltage to the motor 50 to drive the motor 50 to operate.

The DC charge port 30, when connected to the external charge device 60, can receive a DC charge voltage input by the external charge device 60. When the DC charge voltage is higher than an operating voltage of the battery pack 10, the DC charge mode may be entered to directly charge the battery pack 10 with the DC charge voltage. When the DC charge voltage is lower than the operating voltage of the battery pack 10, the boost charge mode may be entered to boost the DC charge voltage, so that the boosted voltage value is higher than the operating voltage of the battery pack 10, so as to charge the battery pack 10 with the boosted voltage. It is understandable that the operating voltage of the battery pack 10 may be the maximum operating voltage of the battery pack 10.

In the DC charge mode, the first end and the second end of the switch module 20 are connected. At this point, the DC charge port 30 may be directly connected to the battery pack 10. The external charge device 60, the DC charge port 30, and the battery pack 10 constitute a direct charge circuit to realize direct charging of the battery pack 10.

In the boost charge mode, the first end and the third end of the switch module 20 are connected. At this point, the switch module 20, the motor controller 40, and the motor 50 are capable of forming a boost circuit. The DC charge port 30 is connected to an input end of the boost circuit, and the battery pack 10 is connected to an output end of the boost circuit. The boost circuit may boost the DC charge voltage input by the external charge device 60 and output it to the battery pack 10, so as to charge the battery pack 10 with the boosted DC voltage.

In the battery pack heating mode, the third end of the switch module 20 connects the neutral point of the motor 50 to the energy storage element C. At this point, the energy storage element C, the switch module 20, the motor controller 40, and the motor 50 are capable of forming a heating circuit. The heating circuit can realize cyclic charging and discharging of the battery pack 10, so that during the charge and discharge cycle, the internal resistance of the battery pack 10 converts electrical energy into thermal energy through a generated oscillating current, thereby heating the battery pack 10.

In a complete charge and discharge cycle of the battery pack 10, the heating circuit can control the battery pack 10 to discharge the energy storage element C, so that the energy storage element C is charged by storing charges. After the energy storage element C stores charges, the heating circuit may control the energy storage element C to release the stored charges to charge the battery pack 10. One discharge-charge process of the battery pack 10 is a complete charge and discharge cycle.

When the electrical apparatus switches between different modes by adjusting the connectivity between the various ends of the switch module 20, in order to avoid short circuits, open circuits, and other faults in the topology circuit in the various modes, it is necessary to ensure that the various ends of the switch module 20 are capable of being fully turned on or fully turned off. For example, when the external charge device 60 is not connected and the third end of the switch module 20 is connected to the energy storage element C and the neutral point of the motor 50, the electrical apparatus operates in the battery pack heating mode. When the third end of the switch module 20 is disconnected, so that the neutral point of the motor 50 is disconnected from the energy storage element C, the electrical apparatus is capable of being switched to the motor drive mode. It is understandable that if the third end of the switch module 20 is not disconnected or not completely disconnected, in the motor drive mode, the three-phase AC voltage will flow into the energy storage element C through the neutral point of the motor 50 and the switch module 20 that is not fully disconnected, causing damage to the energy storage element C.

When the switch module 20 realizes switching between different modes by connecting and disconnecting the various ends, the third end of the switch module 20 needs to remain turned-on in both the boost charge mode and the battery pack heating mode, and the third end of the switch module 20 needs to remain disconnected in the motor drive mode. When the electrical apparatus is converted from the boost charge mode to the motor drive mode, or from the battery pack heating mode to the motor drive mode, it is necessary to ensure that the switch module 20 is capable of fully disconnecting the energy storage element C from the neutral point of the motor 50.

When converted from the boost charge mode or the battery pack heating mode to the motor drive mode, the switch module 20 may disconnect the neutral point of the motor 50 from the energy storage element C. At this point, the motor controller 40 may also be selectively turned on so that the battery pack 10 is capable of being connected to the energy storage element C through the motor controller 40 and the motor 50.

It is understandable that when the switch module 20 fully disconnects the energy storage element C from the neutral point of the motor 50, even if the motor controller 40 is selectively turned on, the battery pack 10 cannot form a complete current loop with the energy storage element C through the motor controller 40 and the motor 50. However, if the energy storage element C and the neutral point of the motor 50 are not disconnected or are not fully disconnected, during the period when the motor controller 40 is turned on, the battery pack 10 is capable of forming a complete loop with the energy storage element C through the motor controller 40 and the motor 50. At this point, the battery pack 10 is capable of supplying power to the energy storage element C by outputting the battery voltage.

By selectively turning on the motor controller 40, when the switch module 20 disconnects the neutral point of the motor 50 from the energy storage element C, it may be determined whether an anomaly occurs in the disconnection state. If the neutral point of the motor 50 is not completely disconnected from the energy storage element C, when the motor controller 40 is turned on, the battery pack 10 is capable of charging the energy storage element C, thereby increasing the voltage across two ends of the energy storage element C. If the neutral point of the motor 50 is completely disconnected from the energy storage element C, when the motor controller 40 is turned on, the battery pack 10 cannot be electrically connected to the energy storage element C, nor can the energy storage element C be charged, and the voltage across two ends of the energy storage element C will not be affected by the battery voltage of the battery pack 10.

By selectively turning on the motor controller 40 and detecting the voltage across two ends of the energy storage element C and its changing trend, it is capable of determining whether an anomaly occurs in the disconnection state of the switch module 20. For example, when it is detected that the voltage across two ends of the energy storage element C does not exceed a preset safe voltage range, it may be determined that the third end of the switch module 20 is completely disconnected. At this point, the neutral point of the motor 50 is not electrically connected to the energy storage element C, and the electrical apparatus is capable of being switched to the motor drive mode to drive the motor 50 to operate. When it is detected that the voltage across two ends of the energy storage element C increases and exceeds the preset safe voltage range, it indicates that the third end of the switch module 20 is not completely disconnected. When the motor controller 40 is turned on, the battery pack 10 charges the energy storage element C, thereby increasing the voltage across two ends of the energy storage element C. At this point, since the switch module 20 is not completely disconnected, if the mode is switched to the motor drive mode and the motor 50 is driven to operate, the energy storage element C will be damaged. Therefore, when detecting that the switch module 20 is not completely disconencted, the electrical apparatus will not be switched to the motor drive mode for operation. It is understandable that the electrical apparatus may also send an alarm to the user to remind the user that the switch module 20 is not completely disconnected.

In this embodiment, by setting the various ports of the switch module 20 to be connected to the DC charge port 30, the battery pack 10, and the neutral point of the motor 50 respectively, the boost charge function and the heating function of the battery pack 10 are capable of being realized by adjusting the connectivity between the various ports of the switch module 20. When the first end and the third end of the switch module 20 are connected, the DC charge port 30 may boost the DC charge voltage provided by the external charge device 60 to charge the battery pack 10. When the third end of the switch module 20 connects the neutral point of the motor 50 to the energy storage element C, it is capable of performing a discharge and charge cycle for the battery pack 10, thereby heating the battery pack 10. When the third end of the switch module 20 is completely disconnected, the battery pack 10, the motor controller 40, and the motor 50 are capable of forming a motor drive circuit to drive the motor 50 to operate normally. When the switch module 20 disconnects the neutral point of the motor 50 from the energy storage element C, it indicates that the electrical apparatus is switched from a boost charge state or a battery pack heating state to a state of driving the motor 50 to operate. The motor controller 40 is capable of connecting the battery pack 10 to the energy storage element C by selectively turning on. If the switch module 20 is capable of completely disconnecting the neutral point of the motor 50 from the energy storage element C, the voltage across two ends of the energy storage element C will not exceed the safe voltage range. If the switch module 20 fails to be completely disconnected, the voltage across two ends of the energy storage element C will be too high when the battery pack 10 is charged. By detecting the voltage across two ends of the energy storage element C, the disconnection state of the switch module 20, that is, whether the switch module 20 completely disconnects the neutral point of the motor 50 from the energy storage element C may be determined, thereby avoiding damage to the components caused by driving the motor 50 when the switch element is not completely disconnected.

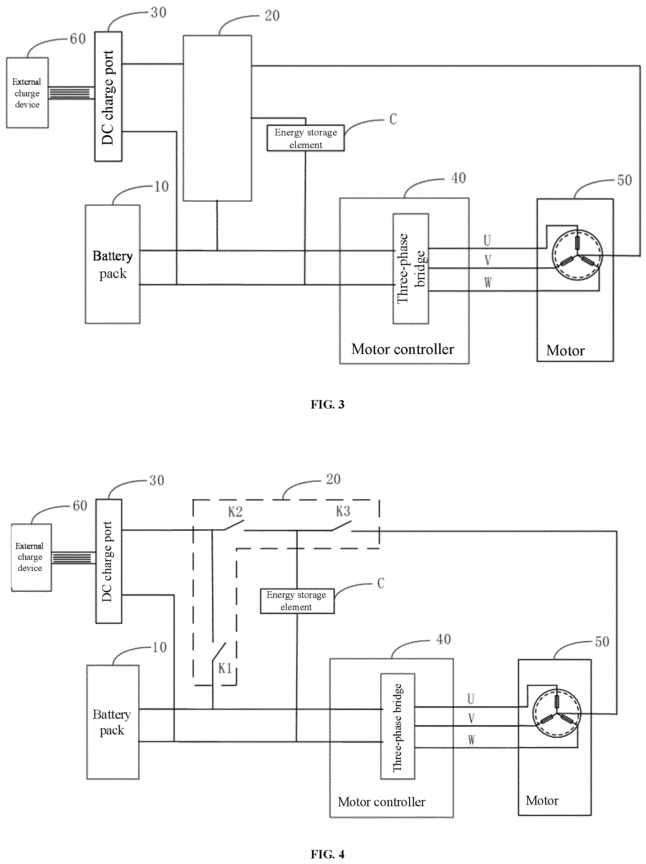

Referring to FIG. 3, according to some embodiments of the present application, a first electrode of the DC charge port 30 may be connected to the first end of the switch module 20, and a second electrode of the DC charge port 30 may be connected to a second electrode of the battery pack 10. A first electrode of the battery pack 10 may be connected to the second end of the switch module 20, and the second electrode of the battery pack 10 may be connected to the first end of the energy storage element C.

The switch module 20 may connect the first end to the third end by connecting the second end of the energy storage element C, the neutral point of the motor 50, and the first electrode of the DC charge port 30. The switch module 20 may connect the neutral point of the motor 50 to the energy storage element C through the third end by connecting the second end of the energy storage element C to the neutral point of the motor 50.

When the second end of the energy storage element C, the neutral point of the motor 50, and the first electrode of the DC charge port 30 are connected to a common node, the electrical apparatus operates in the boost charge mode, and the energy storage element C, the motor 50, and the motor controller 40 are equivalent to constituting a boost circuit. The two ends of the DC charge port 30 are respectively connected to the two ends of the energy storage element C. At this point, the DC charge port 30 is connected to an input end of the boost circuit, and an output end of the boost circuit is connected to the battery pack 10. The DC charge voltage input by the external charge device 60 may be boosted in the boost circuit before charging the battery pack 10.

When the second end of the energy storage element C is connected to the neutral point of the motor 50, the electrical apparatus operates in the battery pack heating mode, and the energy storage element C, the motor 50, and the motor controller 40 are equivalent to constituting a heating circuit. At this point, the DC charge port 30 is not connected to the heating circuit. The heating circuit can alternately discharge and charge the battery pack 10 to convert electrical energy into heat energy to heat the battery pack 10 during the charge and discharge cycle.

By adjusting the connectivity between the energy storage element C, the neutral point of the motor 50, and the DC charge port 30 through the switch module 20, the energy storage element C, the motor 50, and the motor controller 40 can form a boost circuit or a heating circuit. When the DC charge port 30 is connected, a boost circuit is formed, and at this point, the DC charge voltage output by the external charge device 60 may be boosted. When the DC charge port 30 is not connected, a heating circuit is formed, and at this point, the battery pack 10 may be alternately charged and discharged to heat the battery pack 10.

When the second end of the energy storage element C is disconnected from the neutral point of the motor 50, the electrical apparatus may enter the motor drive mode, and the battery pack 10, the motor controller 40, and the motor 50 constitute a motor drive circuit. If the switch module 20 is capable of completely disconnecting the second end of the energy storage element C from the neutral point of the motor 50, when the battery pack 10 supplies power to the motor 50, the three-phase AC voltage will not flow into the energy storage element C through the neutral point of the motor 50. If the switch module 20 fails to successfully disconnect or fails to completely disconnect the second end of the energy storage element C from the neutral point of the motor 50, when the battery pack 10 supplies power to the motor 50, the three-phase AC voltage will flow into the energy storage element C through the neutral point of the motor 50, which may easily cause damage to the energy storage element C.

The switch module 20 may change the connection between the second end of the energy storage element C and the neutral point of the motor 50 from connected to disconnected through on-off control, so that the electrical apparatus is switched from the boost charge mode or the battery pack heating mode to the motor drive mode. After the switch module 20 performs the disconnection operation, the motor controller 40 may be selectively turned on to connect the battery pack 10 to the energy storage element C. If the disconnection state of the switch module 20 is the completely disconnected state, when the motor controller 40 is turned on, the battery pack 10 is not connected to the energy storage element C, and the battery pack 10 does not charge the energy storage element C. If the disconnection state of the switch module 20 is not the completely disconnected state, when the motor controller 40 is turned on, the battery pack 10 and the energy storage element C are capable of being connected through the switch module 20 that is not completely disconnected, so that the voltage across two ends of the energy storage element C increases. At this point, the disconnection state of the switch module 20 may be determined by detecting the voltage across two ends of the energy storage element C.

Referring to FIG. 4, according to some embodiments of the present application, the switch module 20 may include a first switch K1, a second switch K2, and a third switch K3.

A first end of the first switch K1 is connected to the first electrode of the DC charge port 30, and a second end of the first switch K1 is connected to the first electrode of the battery pack 10.

A first end of the second switch K2 is connected to the first electrode of the DC charge port 30, and a second end of the second switch K2 is connected to the second end of the energy storage element C.

A first end of the third switch K3 is connected to the neutral point of the motor 50, and a second end of the third switch K3 is connected to the second end of the energy storage element C.

It is understandable that the first electrode and the second electrode of each of the modules may be a positive electrode and a negative electrode, respectively. The second electrodes of the various modules may be directly connected. The first electrodes of the various modules are connected through the first switch K1, the second switch K2, or the third switch K3, respectively.

When the first switch K1 is turned on, the first electrode and the second electrode of the DC charge port 30 are connected to the first electrode and the second electrode of the battery pack 10 respectively. At this point, the external charge device 60 may directly charge the battery pack 10 through the DC charge port 30.

When the second switch K2 is turned on, the first electrode and the second electrode of the DC charge port 30 are connected to the second end and the first end of the energy storage element C, respectively.

When the third switch K3 is turned on, the first end of the energy storage element C is connected to the second electrode of the battery pack 10, and the second end is connected to the neutral point of the motor 50.

When the second switch K2 is turned on and the third switch K3 is turned on, a DC charge interface is connected to a current loop formed by the energy storage element C, the motor 50, and the motor controller 40. At this point, a voltage input source is the external charge device 60, and the current loop formed by the motor 50 and the motor controller 40 is a boost circuit.

When the second switch K2 is disconnected and the third switch K3 is turned on, the DC charge interface is disconnected from the current loop formed by the energy storage element C, the motor 50, and the motor controller 40. At this point, the voltage input source is the battery pack 10, and the current loop formed by the energy storage element C, the motor 50, and the motor controller 40 is a heating circuit.

When the third switch K3 is disconnected, the neutral point of the motor 50 and the energy storage element C are in a disconnected state. If the third switch K3 is not completely disconnected, when the motor controller 40 is selectively turned on, the battery pack 10 is capable of being electrically connected to the energy storage element C through the motor controller 40 and the motor 50, and output the battery voltage to charge the energy storage element C. If the third switch K3 is completely disconnected, when the motor controller 40 is selectively tumed on, the battery pack 10 and the energy storage element C are not connected, and the voltage across two ends of the energy storage element C will not be affected by the battery pack 10.

The first switch K1, the second switch K2, and the third switch K3 may be relays. It is understandable that a current flowing through a relay is usually a large current. Under the action of the large current and a high voltage, the relay is prone to arcing, causing a contact of the relay to sinter. When the contact of the relay is sintered, the relay cannot be disconnected, which will cause a high safety hazard. Therefore, after the third switch K3 of the switch module 20 changes from an on state to a disconnected state, it is necessary to control the motor controller 40 to be turned on for a period of time and detect the voltage across two ends of the energy storage element C. When the voltage across two ends of the energy storage element C increases abnormally, it indicates that the third switch K3 is not completely disconnected, and the battery pack 10 increases the voltage across two ends of the energy storage element C by charging the energy storage element C. When the voltage across two ends of the energy storage element C does not increase abnormally, it indicates that the third switch K3 is completely disconnected.

In a specific implementation, the electrical apparatus is an electric vehicle, the battery voltage of the battery pack 10 of the electric vehicle is about 800 V, and the safety range of the voltage across two ends of the energy storage element C may be within 60 V. That is, after the third switch K3 is disconnected, the motor controller 40 may be controlled to be tumed on for a period of time. If the voltage across two ends of the energy storage element C exceeds 60 V, it indicates that the third switch K3 is not completely disconnected, and the battery pack 10 charges the energy storage element C. If the voltage across two ends of the energy storage element C does not reach 60 V, it indicates that the third switch K3 is completely disconencted. The battery pack 10 is not connected to the energy storage element C through the neutral point of the motor 50.

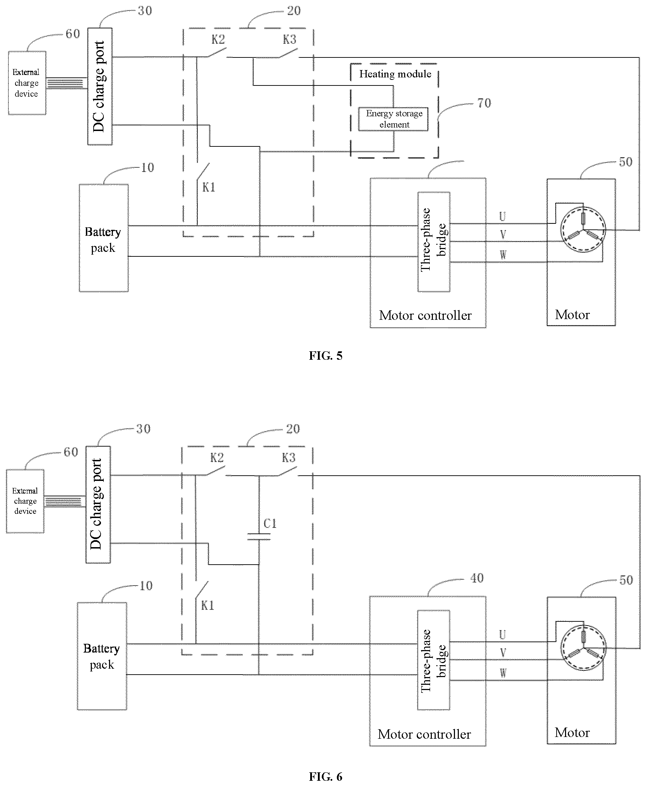

Referring to FIG. 5, according to some embodiments of the present application, the switch topology circuit may further include a heating module 70, and the energy storage element C is arranged in the heating module 70.

The heating module 70 is detachably connected to the switch module 20. When the heating module 70 is connected to the switch module 20, the energy storage element C in the heating module 70 may be connected in series between the common node of the second switch K2 and the third switch K3 and the second electrode of the battery pack 10.

The energy storage element C is arranged in the heating module 70, and the heating module 70 and the switch module 20 are detachably connected. As a result, when the heating module 70 is connected to the switch module 20, the energy storage element C can be connected to the switch topology circuit. When the heating module 70 is disconnected from the switch module 20, the energy storage element C is not connected to the switch topology circuit. The electrical apparatus may use the heating module 70 as an optional module so that the user may select the heating function. In addition, when the user does not select the heating function, the user may also add the heating function by installing the heating module 70.

It should be noted that in the boost charge mode, the voltage input source is the external charge device 60. Even without the energy storage element C, the motor controller 40 and the motor 50 are also capable of forming a boost circuit to boost the DC charge voltage input by the external charge device 60. In the battery pack heating mode, the external charge device 60 is not connected to the current loop. At this point, it is necessary to arrange the energy storage element C to store charges during discharging of the battery pack 10, and charge the battery pack 10 by releasing the charges through the energy storage element C, thereby forming an altemating charge and discharge cycle. Therefore, when the heating module 70 is connected to the switch module 20, the switch topology circuit is capable of achieving boost charge of the battery pack 10 or heating of the battery pack 10 by adjusting the switch module 20. When the heating module 70 is disconnected from the switch module 20, since the energy storage element C is not connected to the current loop, at this point, the switch topology circuit is capable of realizing boost charge of the battery pack 10, but cannot realize heating of the battery pack 10.

Referring to FIG. 6, according to some embodiments of the present application, the energy storage element C includes a first capacitor C1, and the first capacitor C1 may be arranged in the switch module 20.

The first capacitor C1 may also be arranged in the switch module 20. The first capacitor C1 connects the various ports of the switch module 20 to the DC charge port 30, the battery pack 10, and the neutral point of the motor 50 respectively, thereby enabling the connection between the DC charge port 30, the battery pack 10, and the neutral point of the motor 50 to the first capacitor C1 when controlling the connectivity between the various ports.

By arranging the energy storage element C to be integrated in the switch module 20, the number of modules in the electrical apparatus may be reduced, assembling processes in the production process may be reduced, and the production efficiency may be improved.

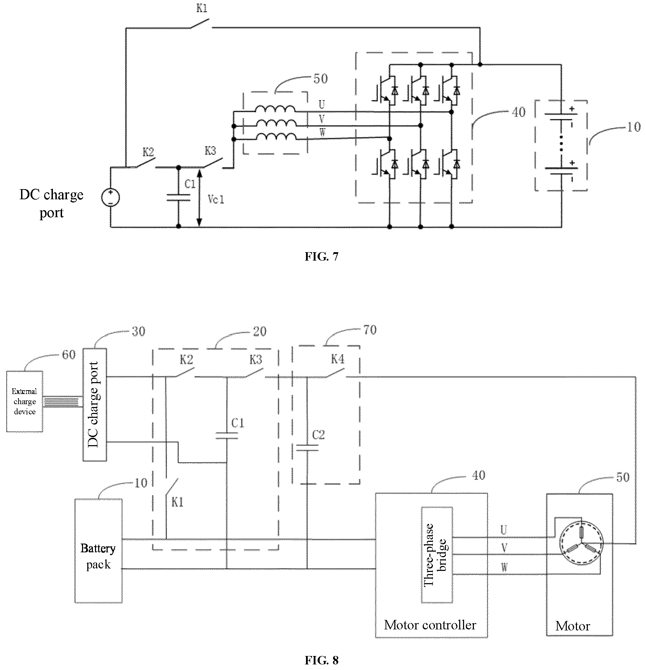

FIG. 7 shows a schematic diagram of a circuit structure corresponding to the embodiment of FIG. 6, and on states of various switches of the switch topology circuit in various modes are described as follows:
In the motor drive mode, the first switch K1, the second switch K2, and the third switch K3 are all in the disconnected state. At this point, the battery pack 10 drives, through the motor controller 40, the motor 50 to operate.

In the DC charge mode, the first switch K1 is turned on, and the second switch K2 and the third switch K3 are in the disconnected state. At this point, both ends of the DC charge port 30 are directly connected to the first electrode and the second electrode of the battery pack 10.

In the boost charge mode, the first switch K1 is disconnected, and the second switch K2 and the third switch K3 are turned on. At this point, the external charge device 60, the DC charge port 30, the first capacitor C1, the motor controller 40, and the motor 50 form a complete boost current loop.

In the battery pack heating mode, the first switch K1 and the second switch K2 are disconnected, and the third switch K3 is turned on. At this point, the first capacitor C1, the motor controller 40, and the motor 50 form a complete heating current loop.

Referring to FIG. 8, according to some embodiments of the present application, the above switch topology circuit may further include a heating module 70. The heating module 70 may include a second capacitor C2 and a fourth switch K4. A first end of the second capacitor C2 is connected to the second electrode of the battery pack 10. The second capacitor C2 is the energy storage element C.

The heating module 70 may connect a second end of the second capacitor C2 to the neutral point of the motor 50 when the fourth switch K4 is turned on. At this point, the first end of the second capacitor C2 is connected to the second electrode of the battery pack 10, and the second end is connected to the neutral point of the motor 50. The second capacitor C2 is capable of forming a heating circuit with the motor controller 40 and the motor 50 to alternately charge and discharge the battery pack 10.

In the case where the switch module 20 is provided with the first capacitor C1, the switch topology circuit may further include the heating module 70 provided with the second capacitor C2. By setting capacitance values of the first capacitor C1 and the second capacitor C2, the capacitance value of the first capacitor C1 is capable of being made not to meet a capacitance requirement of the energy storage element C required for charging and discharging the battery pack 10 in the heating circuit. Therefore, when the heating module 70 is not connected to the switch topology circuit, there is only the first capacitor C1, and the cyclic charge and discharge heating function of the battery pack 10 cannot be realized. When the heating module 70 is connected to the switch topology circuit, the second capacitor C2 can form a heating circuit with the motor controller 40 and the motor 50 to alternately charge and discharge the battery pack 10, thereby heating the battery pack 10.

In the boost charge mode, the first switch K1 is disconnected, the second switch K2, the third switch K3, and the fourth switch K4 are turned on, and the first capacitor C1 and the second capacitor C2 are used as a voltage source to boost the voltage. At this point, the energy storage element C is the first capacitor C1 and the second capacitor C2. If the second capacitor C2 is located in the heating module 70, the heating module 70 is detachably connected to the switch module 20, and when the heating module 70 is not connected to the switch module 20, the energy storage element C is the first capacitor C1.

In the battery pack heating mode, the first switch K1, the second switch K2, and the third switch K3 are disconnected, and the fourth switch K4 is turned on. At this point, the second capacitor C2, the motor 50, the motor controller 40, and the battery pack 10 form an oscillation circuit to heat the battery pack 10. At this point, the energy storage element C is the second capacitor C2.

In the above embodiment, the second capacitor C2 is connected to the neutral point of the motor 50 through the fourth switch K4, and the switch module 20 may connect and disconnect the neutral point of the motor 50 to/from the energy storage element C by controlling the turning on and disconnection of the fourth switch K4. When the fourth switch K4 is completely disconnected, the motor 50 is capable of being disconnected from the energy storage element C. When the fourth switch K4 is not completely disconnected, for example, when the relay is sintered, the neutral point of the motor 50 may still be capable of being electrically connected to the energy storage element C through the fourth switch K4. Therefore, by detecting the voltage across two ends of the energy storage element C, it may be determined whether the battery pack 10 is connected to the energy storage element C, and further determined whether the fourth switch K4 is completely disconnected.

According to some embodiments of the present application, a first end of the fourth switch K4 is connected to the neutral point of the motor 50, and a second end of the fourth switch K4 is respectively connected to the second end of the second capacitor C2 and the third end of the switch module 20.

When the fourth switch K4 is turned on, the two ends of the second capacitor C2 have been connected to a negative electrode loop of the heating module 70 and the neutral point of the motor 50, respectively. At this point, the second capacitor C2, the motor controller 40, the motor 50, and the battery pack 10 are capable of forming a complete heating current loop. Since the battery pack 10 still needs to be heated at this point, the external charge device 60 cannot be connected to the current loop, and the first end of the switch module 20 needs to remain in the disconnected state. The capacitance value of the second capacitor C2 is capable of meeting the capacitance value requirement for the energy storage element C in the heating circuit, and therefore, the second end and the third end of the switch module 20 may remain in the disconnected state, and the first capacitor C1 is not connected to the heating circuit. The battery pack 10 may be heated by the second capacitor C2.

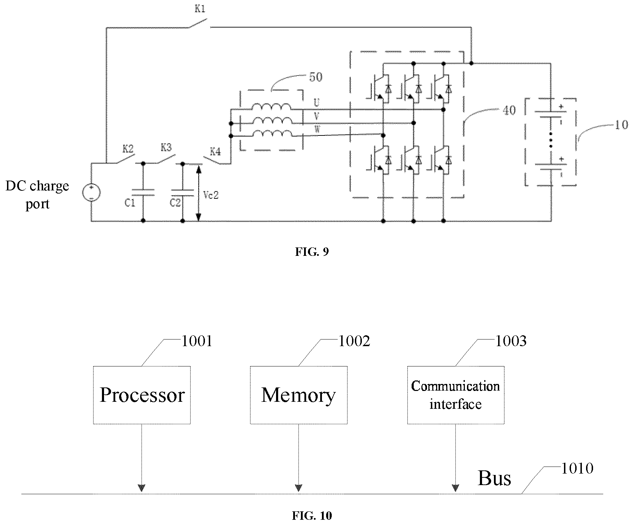

FIG. 9 shows a schematic diagram of a circuit structure corresponding to the embodiment of FIG. 8. Compared with the schematic diagram of the circuit structure shown in FIG. 7, FIG. 9 further includes the second capacitor C2 and the fourth switch K4.

In the motor drive mode, the first switch K1, the second switch K2, the third switch K3, and the fourth switch K4 are all disconnected. At this point the battery pack 10 drives, through the motor controller 40, the motor 50 to operate.

In the DC charge mode, the first switch K1 is turned on, and the second switch K2, the third switch K3, and the fourth switch K4 are disconnected. At this point, both ends of the DC charge port 30 are directly connected to the first electrode and the second electrode of the battery pack 10.

In the boost charge mode, the first switch K1 is disconnected, and the second switch K2, the third switch K3, and the fourth switch K4 are turned on. At this point, the external charge device 60, the DC charge port 30, the first capacitor C1, the second capacitor C2, the motor controller 40, and the motor 50 form a complete boost current loop.

In the battery pack heating mode, the first switch K1, the second switch K2, and the third switch K3 are disconnected, and the fourth switch K4 is turned on. At this point, the second capacitor C2, the motor controller 40, and the motor 50 form a complete heating current loop.

According to some embodiments of the present application, the switch module 20 may tum on the first end and the third end under a first preset condition so that the boost circuit boosts the DC charge voltage input by the external charge device 60 to charge the battery pack 10. The first preset condition may include that the DC charge voltage of the external charge device 60 is lower than an operating voltage of the battery pack 10.

When the external charge device 60 is connected to the DC charge port 30, the magnitude of the DC charge voltage of the external charge device 60 may be detected. When the DC charge voltage is lower than the operating voltage of the battery pack 10, it is determined that the first preset condition is met. At this point, the battery pack 10 cannot be charged directly by the DC charge voltage. It is necessary to connect the first end and the third end of the switch module 20 to boost the DC charge voltage through the boost circuit.

Through the first preset condition, when the voltage of the external charge device 60 is high, it may be directly connected to the battery pack 10 to charge the battery pack 10. When the voltage provided by the extemal charge device 60 is low, the first end and the third end of the switch module 20 are connected to boost the voltage. For an external charge device 60 with a high-voltage or low-voltage output voltage, the switch topology circuit is compatible to achieve charging of the battery pack 10.

According to some embodiments of the present application, the switch module 20 may connect the second end to the third end under a second preset condition so that the heating circuit performs cyclic charge and discharge on the battery pack 10, thereby heating the battery pack 10. The second preset condition may include that the battery temperature of the battery pack 10 is lower than a temperature threshold.

By detecting the battery temperature of the battery pack 10, when the battery temperature of the battery pack 10 is lower than the temperature threshold, it may be determined that the battery pack 10 is in a low-temperature environment and meets the second preset condition. At this point, the second end and the third end of the switch module 20 may be connected to achieve heating of the battery pack 10 to increase the battery temperature of the battery pack 10.

Through the second preset condition, when the battery temperature of the battery pack 10 is low, a heating circuit may be formed by the switch module 20 to charge and discharge the battery pack 10, thereby heating the battery pack 10 so that the battery temperature of the battery pack 10 reaches a normal temperature range.

It is understandable that since the charging efficiency of the battery pack 10 is low in the low-temperature environment, when the external charge device 60 is connected to the DC charge interface, the battery temperature of the battery pack 10 needs to be detected. When the battery temperature is low, the battery pack 10 needs to be heated by the heating circuit first so that the battery temperature reaches the suitable temperature range before the external charge device 60 being capable of being connected to the battery pack 10 to charge the battery pack 10. Before connecting the external charge device 60 to the battery pack 10, it is also necessary to detect the output voltage of the external charge device 60 to determine, according to the output voltage, whether the method of connecting the external charge device 60 to the battery pack 10 is a DC charge method or a boost charge method.

Referring to FIG. 7 or FIG. 9, according to some embodiments of the present application, the motor controller 40 may include a three-phase bridge, and the three-phase bridge includes three bridge arm groups. The bridge arm group includes an upper bridge arm and a lower bridge arm connected in series, and the first electrode and the second electrode of the battery pack 10 are connected to a first input end and a second input end of the motor controller 40, respectively.

The upper bridge arm in the bridge arm group is connected to the first input end of the motor controller 40, and the lower bridge arm is connected to the second input end of the motor controller 40. A common node of the three bridge arm groups are respectively connected to the three-phase input end of the motor 50, and the common node is a connection point of the upper bridge arm and the lower bridge arm.

When forming a heating circuit, the motor controller 40 may drive the upper bridge arm and the lower bridge arm of at least one bridge arm group among the three bridge arm groups to be alternately turned on, so as to cyclically charge and discharge the battery pack 10, thereby heating the battery pack 10.

The three-phase input end of the motor 50 is respectively connected to the three bridge arm groups of the motor controller 40. Each phase of the motor 50 further includes a winding inductor. After the winding inductor is connected to the corresponding bridge arm group, it may form a charge and discharge loop with the battery pack 10 and the energy storage element C. By controlling the upper bridge arm and the lower bridge arm to be turned on alternately, the battery pack 10 may be discharged and charged alternately. When the motor controller 40 drives a bridge arm group to be alternately turned on, cyclic charge and discharge performed on the battery pack 10 may be realized. By increasing the number of bridge arm groups driven by the motor controller 40, the power during discharge or charge of the battery pack 10 is capable of being increased. Accordingly, when the charge and discharge power increases, the oscillating current generated by the battery pack 10 during the charge and discharge process also increases, so that the internal resistance of the battery pack 10 generates more heat, thereby increasing the heating power and heating efficiency.

By setting the number of bridge arm groups driven in the heating circuit, the heating power and heating efficiency of the battery pack 10 may be adjusted. When the battery pack 10 needs to be heated up quickly or the battery temperature is significantly different from the appropriate temperature range, the number of driven bridge arm groups may be increased to quickly increase the battery temperature of the battery pack 10. When the battery temperature of the battery pack 10 is close to the appropriate temperature range or the remaining power of the battery pack 10 is low, the number of driven bridge arm groups may be reduced to reduce the power consumed in the heating process.

According to some embodiments of the present application, when forming a boost circuit, the above motor controller 40 may drive the upper bridge arm and the lower bridge arm of at least one bridge arm group among the three bridge arm groups to be alternately turned on, so as to boost the DC charge voltage of the external charge device 60 and then charge the battery pack 10 with the boosted voltage.

A typical Boost circuit includes an inductor, a diode, and a switch tube. The inductor can store or release energy by suppressing the current, the diode can limit the current direction, and the switch tube can store and release charges by alternating turning on and turning off to control the inductor. Taking a bridge arm group as an bridge arm group is connected to a phase of the motor 50, the winding inductor of the motor 50 on this phase may be used as the inductor in the Boost circuit, a reverse diode of the upper bridge arm may be used as a diode, and the lower bridge arm may be used as a switch tube. By controlling the upper bridge arm and the lower bridge arm to be turned on alternately, the boost function of the Boost circuit may be realized, and the DC charge voltage input by the external charge device 60 may be boosted. By adjusting the duty cycle of the on time of the upper bridge arm and the lower bridge arm, the boost multiple may be adjusted so that the boosted DC charge voltage is capable of being greater than the operating voltage of the battery pack 10, and therefore, the boosted voltage is capable of charging the battery pack 10.

By driving any bridge arm group and the winding inductor corresponding to the bridge arm group in the motor 50, the DC charge voltage can be boosted. Increasing the number of driven bridge arm groups will not change the magnitude of the boosted voltage, but it can increase the output power of the boost circuit. Therefore, by adjusting the number of bridge arm groups driven in the motor controller 40, the charge power of the battery pack 10 during the charge process is capable of being increased. According to the actual charge power required by the battery pack 10, a corresponding number of bridge arm groups may be driven.

After the switch module 20 disconnects the neutral point of the motor 50 from the energy storage element C, the motor controller 40 may selectively turn on the upper bridge arm of one of the bridge arm groups. In a specific implementation, the method of controlling the upper bridge arm to be turned on is sending high-level and low-level pulse signals to the upper bridge arm of the corresponding bridge arm group. If a valid signal is of a high level, the upper bridge arm is turned on when receiving the high level and turned off when receiving a low level. The high-level and low-level pulse signals mentioned above may be PWM signals.

When the upper bridge arm is turned on, the battery pack 10 may output the battery voltage of the battery pack 10 through the turned-on upper bridge arm and the inductor of the motor 50 connected to the bridge arm group. If the switch module 20 fails to completely disconnect the neutral point of the motor 50 from the energy storage element C, the battery voltage is capable of charging the energy storage element C when the upper bridge arm is turned on. If the switch module 20 has completely disconnected the neutral point of the motor 50 from the energy storage element C, the battery voltage cannot charge the energy storage element C when the upper bridge arm is turned on. By detecting the voltage across two ends of the energy storage element C, it may be determined, according to the voltage across two ends, whether the battery pack 10 charges the energy storage element C, thereby further determining whether the switch module 20 has completely disconnected the neutral point of the motor 50 from the energy storage element C.

The switch module 20 disconnects the neutral point of the motor 50 from the energy storage element C, which means that the switch module 20 disconnects the switch connecting the energy storage element C and the neutral point of the motor 50. For example, in the above embodiment, when the energy storage element C includes the first capacitor C1, the switch connected between the first capacitor C1 and the neutral point of the motor 50 is the third switch K3, and the switch module 20 may control the third switch K3 to be disconnected, so as to disconnect the neutral point of the motor 50 from the energy storage element C. As shown in FIG. 7, at this point, the voltage across two ends of the energy storage element C is a voltage Vc1 across two ends of the first capacitor C1.

When the energy storage element C includes the second capacitor C2, the switch connected between the second capacitor C2 and the neutral point of the motor 50 is the fourth switch K4, and the switch module 20 may control the fourth switch K4 to be disconnected, so as to disconnect the neutral point of the motor 50 from the energy storage element C. As shown in FIG. 9, at this point, the voltage across two ends of the energy storage element C is a voltage Vc2 across two ends of the second capacitor C2.

The third switch K3 and the fourth switch K4 may be relays, and the relays are prone to electric shock and sintering under large currents and high voltages, so that the relays cannot be completely disconnected. By turning on the upper bridge arm of the motor controller 40, it may be determined, according to whether the battery pack 10 is capable of charging the energy storage element C, whether the relay connected between the neutral point and the energy storage element C is sintered.

FIG. 10 is a schematic diagram of a hardware structure of a state detection device for a switch module according to an embodiment of the present application.

The state detection device for a switch module may include a processor 1001 and a memory 1002 storing computer program instructions.

Specifically, the processor 1001 may include a central processing unit (CPU), or an Application-Specific Integrated Circuit (ASIC), or one or more integrated circuits that may be configured to implement the embodiments of the present application.

The memory 1002 may include a mass memory for data or instructions. As an example rather than a limitation, the memory 1002 may include a Hard Disk Drive (HDD), a floppy disk drive, a flash memory, an optical disc, a magneto-optical disc, a magnetic tape, a Universal Serial Bus (USB) drive, or a combination of two or more thereof. The memory 1002 may include a removable or non-removable (or fixed) medium, where appropriate. The memory 1002 may be internal or external to a state detection device for a switch module, where appropriate. In a specific example, the memory 1002 is a non-volatile solid-state memory.

The memory may include a read-only memory (ROM), a random-access memory (RAM), a disk storage medium device, an optical storage medium device, a flash memory device, or an electrical, optical, or another physical/tangible memory device. Therefore, typically, the memory includes one or a plurality of tangible (non-transitory) readable storage media (for example, memory devices) encoded with software including computer-executable instructions, where the software, when executed (for example, by one or a plurality of processors), is operable to perform the operations described with reference to the method according to an aspect of the present disclosure.

The processor 1001 reads and executes the computer program instructions stored in the memory 1002 to implement any one of the state detection methods for a switch module in the above embodiments.

As an example, the state detection device for a switch module may further include a communication interface 1003 and a bus 1010. As shown in FIG. 10, the processor 1001, the memory 1002, and the communication interface 1003 are connected and complete communication with each other through the bus 1010.

The communication interface 1003 is mainly configured to implement communication between the modules, apparatuses, units, and/or devices in the embodiments of the present application.

The bus 1010 includes hardware, software, or both hardware and software, and couples the components of the state detection device for a switch module to each other. For example and non-restrictively, the bus may include an accelerated graphics port (AGP) or other graphics buses, an enhanced industry standard architecture (EISA) bus, a front side bus (FSB), HyperTransport (HT) interconnection, an industry standard architecture (ISA) bus, infiniband interconnection, a low pin count (LPC) bus, a memory bus, a microchannel architecture (MCA) bus, a peripheral component interconnect (PCI) bus, a PCI-Express (PCI-X) bus, a serial advanced technology attachment (SATA) bus, a Video Electronics Standards Association local bus (VLB), or other appropriate buses, or a combination of two or more of the above. The bus 1010 may include one or a plurality of buses, where appropriate. Although specific buses are described and illustrated in the embodiment of the present application, any suitable bus or interconnection is contemplated in the present application.

The state detection device for a switch module may implement the state detection method for a switch module in the above embodiment.

In addition, in combination with the state detection method for a switch module in the above embodiment, the embodiment of the present application may provide a computer storage medium to implement it. The computer storage medium stores computer program instructions, and the computer program instructions, when executed by a processor, implement any one of the state detection methods for a switch module in the above embodiments.

Herein, the term "include", "comprise" or other variations thereof are intended to cover non-exclusive including, so that a process, method, product, or device including a series of elements not only includes the elements, but also includes other elements not clearly listed, or further includes elements inherent to the process, method, product, or device.

It should be noted that, without conflict, embodiments in the present application and features in the embodiments may be combined together.

Finally, it should be noted that, the above embodiments are merely used for describing the technical solution of the present application, instead of limiting the present application; although the present application is described in detail with reference to the foregoing embodiments, persons of ordinary skill in the art should understand that they can still make modifications on the technical solution recorded in the above embodiments, or perform equivalent replacements on a part of technical features thereof; these modifications or replacements are not intended to make the essences of the corresponding technical solutions depart from the spirit and scope of the technical solutions of the embodiments of the present application.

## Claims

1. A state detection method for a switch module, comprising:
connecting a battery pack to a switch module when the switch module is disconnected, so that the battery pack forms a first charge loop with an energy storage element through the switch module;
performing voltage detection on the energy storage element to obtain a first detection voltage; and
determining, according to the first detection voltage, whether the switch module is completely disconnected.

2. The state detection method for a switch module according to claim 1, wherein the connecting a battery pack to a switch module comprising:
sending a charge signal to a charge control module, so that the charge control module connects the battery pack to the switch module according to the charge signal.

3. The state detection method for a switch module according to claim 2, wherein the performing voltage detection on the energy storage element to obtain a first detection voltage comprises:
sending a first voltage detection signal to a voltage detection module when the battery pack is connected to the switch module; and
receiving the first detection voltage obtained and sent by the voltage detection module after performing voltage detection on the energy storage element.

4. The state detection method for a switch module according to claim 3, wherein the charge control module comprises at least two current branches; and the sending a first voltage detection signal to a voltage detection module comprises:
determining a first current branch connected between the battery pack and the switch module in the charge control module; and
sending the first voltage detection signal to the voltage detection module, so that the voltage detection module performs voltage detection on the energy storage element through a current branch other than the first current branch.

5. The state detection method for a switch module according to claim 4, wherein before the connecting a battery pack to a switch module when the switch module is disconnected, the method further comprises:
connecting a discharge module to the switch module when the switch module is turned on, so that the discharge module forms a first discharge loop with the energy storage element through the switch module;
performing voltage detection on the energy storage element to obtain a second detection voltage; and
sending a disconnect signal to the switch module when the second detection voltage reaches a safe voltage range.

6. The state detection method for a switch module according to claim 5, wherein the performing voltage detection on the energy storage element to obtain a second detection voltage comprises:
determining a second current branch connected between the discharge module and the switch module in the charge control module; and
sending a second voltage detection signal to the voltage detection module, so that the voltage detection module performs voltage detection on the energy storage element through a current branch other than the second current branch.

7. The state detection method for a switch module according to claim 1, wherein the determining, according to the first detection voltage, whether the switch module is completely disconnected comprises:
acquiring a safe voltage range; and
controlling the battery pack to stop operating when the first detection voltage exceeds the safe voltage range.

8. A state detection circuit for a switch module, comprising:
a switch module;
an energy storage element, the energy storage element being connected to a first end of the switch module; and
a control module, the control module being configured to connect a second end of the switch module to the battery pack when the switch module is disconnected, and determine, according to a first detection voltage of the energy storage element, whether the switch module is completely disconnected.

9. The state detection circuit for a switch module according to claim 8, wherein the circuit further comprises:
a charge control module connected between the switch module and the battery pack, the charge control module being configured to, when receiving a charge signal, connect the battery pack to the switch module.

10. The state detection circuit for a switch module according to claim 9, wherein the circuit further comprises:
a voltage detection module electrically connected to the energy storage element, the voltage detection module being configured to, when receiving a first voltage detection signal, perform voltage detection on the energy storage element to obtain the first detection voltage, and/or, when receiving a second voltage detection signal, perform voltage detection on the energy storage element to obtain a second detection voltage.

11. The state detection circuit for a switch module according to claim 10, wherein the charge control module comprises at least two current branches, and the charge control module is configured to connect the battery pack to the switch module through a first current branch, and/or connect a discharge module to the switch module through a second current branch; and
the voltage detection module is configured to, when receiving the first voltage detection signal, determine a third current branch from the plurality of current branches, and perform voltage detection on the energy storage element through the third current branch and the switch module, and/or, when receiving the second voltage detection signal, determine a fourth current branch from the plurality of current branches, and perform voltage detection on the energy storage element through the fourth current branch and the switch module.

12. The state detection circuit for a switch module according to claim 11, wherein the charge control module comprises a motor controller, the motor controller comprises three bridge arm groups, and each of the bridge arm groups forms a current branch with the switch module.

13. A state detection device for a switch module, comprising a processor and a memory storing computer program instructions; wherein
the computer program instructions, when executed by the processor, cause the state detection device for a switch module to implement the state detection method for a switch module according to claims 1 to 7.

14. A computer storage medium, storing computer program instructions thereon, wherein the computer program instructions, when executed by a processor, implement the state detection method for a switch module according to claims 1 to 7.
